# EUROPÄISCHE PATENTSCHRIFT

(11) **EP 1 444 736 B1**
(45) Veröffentlichungstag und Bekanntmachung des Hinweises auf die Patenterteilung: **02.04.2008**
(21) Anmeldenummer: 02785059.3
(22) Anmeldetag: 14.11.2002
(51) Int. Cl.: H01L 31/0216, H01L 27/146

(54) **FARBFILTERMATRIX FÜR EINEN OPTISCHEN BILDSENSOR**
COLOUR-FILTER ARRAY FOR AN OPTICAL-IMAGE SENSOR
MATRICE DE FILTRE COLORE POUR CAPTEUR D'IMAGE OPTIQUE

(30) Priorität: 15.11.2001 DE 10155819
(43) Veröffentlichungstag der Anmeldung: 11.08.2004
(73) Patentinhaber: STMicroelectronics N.V., 1118 BH Schiphol Airport Amsterdam (NL)
(72) Erfinder: WAGNER, Michael, 01900 Bretnig-Hauswalde (DE); RIEVE, Peter, 51570 Windeck-Dattenfeld (DE); SEIBEL, Konstantin, 57074 Siegen (DE)
(74) Vertreter: Hudler, Frank
(86) Internationale Anmeldenummer: PCT/DE2002/004220
(87) Internationale Veröffentlichungsnummer: WO 2003/047273

(56) Entgegenhaltungen:
- EP-A- 0 629 926
- WO-A-88/05180
- US-A- 4 441 123
- US-B1- 6 235 549

## Beschreibung

Die Erfindung betrifft eine Farbfiltermatrix für einen optischen Bildsensor mit einer matrixorganisierten oder linearen Anordnung von Bildpunkten, die bildpunktweise mit einer elektronischen Schaltung zur Umsetzung der Helligkeitsinformation jedes Bildpunktes in elektrische Signale verbunden sind, wobei über jedem Bildpunkt ein rechteckiger Farbfilter einer vorgegebenen Farbe angeordnet ist und mehrere unmittelbar aneinander angrenzende Bildpunkte bildpunktweise mit Filtern unterschiedlicher Farbe zusammen eine Basiszelle ergeben und eine Vielzahl von Basiszellen zusammen den matrixorganisierten oder linearen Bildsensor ergeben.

Eine derartige Farbfiltermatrix kann beispielsweise für TFA-Bildsensoren (Thin Film on ASIC - Bildsensoren) zur Gewinnung von RGB-Farbinfomationen verwendet werden, die aus einer matrixorganisierten oder linearen Anordnung von Bildpunkten bestehen. Die zum Betrieb des Bildsensors erforderlichen elektronischen Schaltungen, wie Pixelelektronik, Peripherieelektronik, Systemelektronik sind üblicherweise in CMOS-basierter Siliziumtechnologie realisiert und bilden den anwenderspezifischen Schaltkreis (ASIC).

Durch eine isolierende Schicht vom ASIC getrennt und mittels elektrischer Kontakte (Vias) mit diesem verbunden, ist auf dem ASIC-Schaltkreis eine Mehrschichtanordnung als Photodiode angeordnet, welche die Umwandlung elektromagnetischer Strahlung (Licht) in einen von der Intensität der Strahlung abhängigen Photostrom vornimmt. Dieser Photostrom wird an bestimmten, in jedem Pixel vorhandenen Kontakten der darunter liegenden Pixelelektronik übergeben. Ein solcher TFA-Bildsensor wird in B. Schneider, P. Rieve, M. Böhm, "Image Sensors in TFA (Thin Film on ASIC) Technology", ed. B. Jähne, Hausecker, P. Geißler, Handbook of Computer Vision and Applications, pp. 237 - 270, Academic Press, San Diego, 1999, beschrieben.

Sollen mit derartigen Bildsensoren Farben erkannt werden, müssen üblicherweise Farbfilter eingesetzt werden, die auf einzelne Bildpunkte (Pixel) aufgebracht werden. Derartige Farbfilter zur Gewinnung von Farbinformationen können im einfachsten Fall mit Hilfe von Farblacken realisiert werden, die Licht nur in bestimmten Wellenlängenbereichen passieren lassen. Ein Beispiel hierfür geht aus der US 3 971 065 A hervor. Eine andere Möglichkeit besteht in der Verwendung von Interferenzfiltern. Als Farbinfomation werden üblicherweise RGB (Rot Grün Blau) Informationen, CMY (Cyan Magenta Yellow) Informationen oder sonstige andere Informationen aus beliebigen Filterverfahren verwendet.

Um nun die RGB- oder CMY-Farbinformationen erhalten zu können, ist es notwendig, die unterschiedlichen Farben der Farbfilter bildpunktweise derart zu gruppieren, dass mehrere nahe beieinander liegende Pixel die Farbinformationen einer Basiszelle ergeben. Eine einfache Möglichkeit der Gruppierung besteht in der Bildung eines Quadrates als Basiszelle, bei der im Fall von RGB-Filtern diagonal angeordnet zwei Grün-Filter, und jeweils ein Rot- und ein Blau-Filter vorgesehen sind. Selbstverständlich sind auch andere Konfigurationen der Basiszelle denkbar. Werden nun derartige Basiszellen aneinandergereiht, entsteht eine gleichmäßige Farbfiltermatrix auf einem Bildsensor, der beispielsweise ein TFA-Bildsensor sein kann.

Ein wesentliches Merkmal von TFA-Bildsensoren ist die Tatsache, dass fotoaktive Bereiche, hier Fotodioden, benachbarter Bildpunkte direkt aneinander stoßen. In diesem Fall ist ein Flächenfüllfaktor von 100 % anzusetzen. Soll nun ein Schwarz/Weiß-Sensor durch Aufbringen einer Farbfiltermatrix in einen Farbsensor konvertiert werden, muss unter allen Umständen vermieden werden, dass Weißlicht eine Verfälschung der Farbinformation bewirkt. Es hat sich gezeigt, dass beim Aufbringen einer Farbfiltermatrix ohne entsprechende technische Maßnahmen nicht verhindert werden kann, dass im Grenzbereich zwischen den einzelnen Farbfiltern ungefiltertes Licht zur Photodiode gelangt. Das Ergebnis wäre eine Verfälschung der RGB-, CMY- oder sonstigen Farbsignale.

Die US-B1-6 235 549 zeigt eine Abschirmung zur Anpassung der Farbempfindlichkeit von Pixeln. Zu diesem Zweck wird über der Matrix jedes Pixels eine Maske aus Metall mit unterschiedlich großen Öffnungen angeordnet. Die Größe der Fenster ist von der Empfindlichkeit des Sensors für die jeweilige Wellenlänge abhängig. Der nötige Farbfilter befindet sich über dieser Maske. Die Maske deckt auch die Zwischenräume zwischen den Farbfiltern ab.

Aus der EP-A-0 629 926 einen Imageprozessor, bei dem ein Überlapp im Grenzbereich zwischen einem Infrarot Filter und einem Filter für sichtbares Licht vorgesehen ist, der die Filter für Blau, Grün, Rot überdeckt. Zwischen den Filtern für Blau, Grün, Rot befindet sich ein deutlicher Abstand, durch den sichtbares Licht eindringen kann.

In der WO 885180 A wird ein Farbfiltermaterial für verschiedene Farben beschrieben, mit dem Farbfilterarrays realisierbar sind. Benachbarte Filterelemente können sich überlappen, um einen besseren Kontrast zu erreichen.

Eine ähnliche Lösung geht auch aus der US-A-4 441 123 hervor.

Der Erfindung liegt daher die Aufgabe zugrunde, eine Farbfiltermatrix für einen optischen Bildsensor zu schaffen, mit dem eine Verfälschung der Farbsignale durch ungefiltertes Weißlicht sicher verhindert wird.

Die der Erfindung zugrunde liegende Aufgabe wird bei einer Farbfiltermatrix der eingangs genannten Art dadurch gelöst, dass sich zwischen angrenzenden Filtern unterschiedlicher Farbe Grenzbereiche befinden, in denen jeweils ein Freiraum angeordnet ist, der mit einem annähernd lichtdichten Material gefüllt ist.

Mit dieser einfachen Grundidee lassen sich Verfälschungen durch eindringendes Weißlicht mit einfachen Mitteln sicher verhindern. Die Qualität der Farbsignale wird dadurch deutlich verbessert.

Der Freiraum zwischen den Farbfiltern der Farbfiltermatrix kann nachträglich eingebracht worden sein, was mit einem fotolithografischen Verfahren und anschließenden Ätzen möglich ist.

Für das lichtdichte Material kann bevorzugt ein Metall, oder ein anderes lichtdichtes Material genügender Schichtstärke verwendet werden.

Das lichtdichte Material im Freiraum kann auch aus einem Polymer bestehen.

Die Erfindung soll nachfolgend an einem Ausführungsbeispiel näher erläutert werden. In den zugehörigen Zeichnungen zeigen:
- Fig. 1:: zeigt eine Draufsicht auf eine schematische Darstellung einer Farbfiltermatrix mit einem erfindungsgemäßen Überlapp im Grenzbereich benachbarter Farbfilter;
- Fig. 2:: eine Querschnittdarstellung der Farbfiltermatrix nach Fig. 1;
- Fig. 3:: eine Querschnittdarstellung einer Farbfiltermatrix mit einer lichtdichten Abdeckung über den Grenzbereichen zwischen benachbarten Farbfiltern; und
- Fig. 4:: eine Farbfiltermatrix mit in einem Freiraum zwischen den Farbfiltern eingebrachten Metallstreifen.

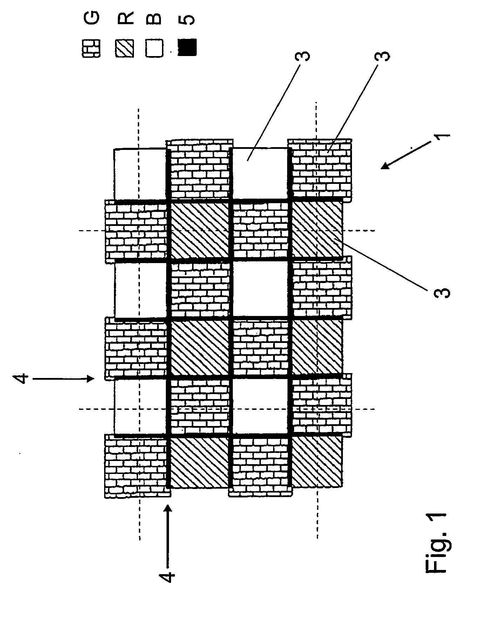

Fig. 1 zeigt eine Farbfiltermatrix 1 für einen optischen Bildsensor mit einer matrixorganisierten oder linearen Anordnung von Bildpunkten 2, die bildpunktweise mit einer nicht dargestellten elektronischen Schaltung zur Umsetzung der Helligkeitsinformation jedes Bildpunktes 2 in elektrische Signale verbunden ist. Über jedem Bildpunkt 2 ist ein rechteckiger Farbfilter 3 einer vorgegebenen Farbe R (Rot), G (Grün) und B (Blau) angeordnet. Mehrere unmittelbar aneinander angrenzende Bildpunkte 2 bilden dabei bildpunktweise mit Filtern unterschiedlicher Farbe zusammen eine Basiszelle G/G/B/R und eine Vielzahl von Basiszellen zusammen ergeben den matrixorganisierten oder linearen Bildsensor.

Die der Erfindung zugrundeliegende Aufgabe kann im einfachsten Fall dadurch realisiert werden, dass die Grenzbereiche 4 zwischen angrenzenden Farbfiltern 3 unterschiedlicher Farbe eine deutlich verringerte Lichtdurchlässigkeit aufweisen.

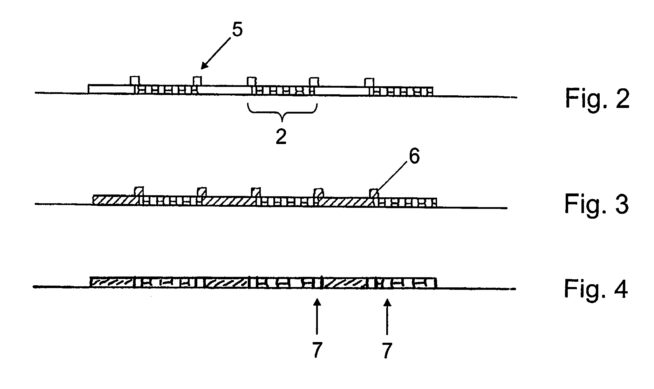

Eine andere Möglichkeit besteht darin, die Farbfilter 3 so auszugestalten, dass diese in den Grenzbereichen zu benachbarten Filtern einen Überlapp 5 aufweisen (Fig. 1 und 2).

Um das unerwünschte Eindringen von Weißlicht in den Grenzbereich 4 zwischen den Farbfiltern 3 zu verhindern, kann dieser Grenzbereich 4 zwischen den Farbfiltern 3 zumindest annähernd lichtdicht abgedeckt werden. Dieses Abdecken kann durch nicht transparente Streifen 6 (Fig. 3) erfolgen. Diese Streifen 6 können aus Metall genügender Schichtstärke, oder aus absorbierenden Polymerschichten bestehen.

In einer besonderen Variante der Erfindung befindet sich zwischen den Farbfiltern ein schmaler Freiraum 7, der mit einem annähernd lichtdichten Material ausgefüllt ist (Fig. 4).

### Bezugszeichenliste

- 1: Farbfiltermatrix
- 2: Bildpunkt
- 3: Farbfilter
- 4: Grenzbereich
- 5: Überlapp
- 6: nicht transparenter Streifen
- 7: Freiraum
- 8: lichtdichtes Material

- R: Rot
- G: Grün
- B: Blau

## Patentansprüche

1. Farbfiltermatrix (1) für einen optischen Bildsensor mit einer matrixorganisierten oder linearen Anordnung von Bildpunkten (2), die bildpunktweise mit einer elektronischen Schaltung zur Umsetzung der Helligkeitsinformation jedes Bildpunktes (2) in elektrische Signale verbunden sind, wobei über jedem Bildpunkt (2) ein rechteckiger Farbfilter einer vorgegebenen Farbe (R, G, B) angeordnet ist und mehrere unmittelbar aneinander angrenzende Bildpunkte (2) bildpunktweise mit Farbfiltern (3) unterschiedlicher Farbe zusammen eine Basiszelle ergeben und eine Vielzahl von Basiszellen zusammen den matrixorganisierten oder linearen Bildsensor ergeben, **dadurch gekennzeichnet, dass** sich zwischen angrenzenden Farbfiltern (3) Grenzbereiche (4) befinden, in denen jeweils ein Freiraum (7) angeordnet ist, der mit einem annähernd lichtdichten Material gefüllt ist.

2. Farbfiltermatrix nach Anspruch 1, **dadurch gekennzeichnet, dass** das lichtdichte Material im Freiraum (7) aus Metall besteht.

3. Farbfiltermatrix nach Anspruch 1 oder 2, **dadurch gekennzeichnet, dass** das lichtdichte Material im Freiraum (7) aus einem Polymer besteht.

4. Farbfiltermatrix nach einem der Ansprüche 1 bis 4, **dadurch gekennzeichnet, dass** der Freiraum (7) zwischen den Farbfiltern (3) durch nachträgliches Ätzen eingebracht ist.

## Claims

1. Colour filter array (1) for an optical image sensor comprising pixels (2) arranged in a matrix or a line, each pixel being connected to an electronic circuit for converting the information concerning the luminosity of each pixel (2) into electric signals, a rectangular colour filter of a predetermined colour (R, G, B) being arranged over each pixel (2) and a plurality of pixels (2) which are directly adjacent to one another constituting pixel by pixel with colour filters (3) of differing colour a base cell and a large number of base cells together constituting the matricial or linear image sensor, **characterised in that** border regions (4), containing a respective free space (7) which is filled with an approximately light-proof material, are located between adjacent colour filters (3).

2. Colour filter array according to Claim 1, **characterised in that** the light-proof material in the free space (7) is made of metal.

3. Colour filter array according to Claim 1 or 2, **characterised in that** the light-proof material in the free space (7) is made of a polymer.

4. Colour filter array according to any one of Claims 1 to 4, **characterised in that** the free space (7) is introduced between the colour filters (3) by subsequent etching.

## Revendications

1. Matrice de filtre couleur (1) pour un capteur optique d'image, ayant une disposition en matrice ou une disposition linéaire de pixels (2), reliée à un circuit électronique pour convertir l'information de luminosité de chaque pixel (2) en signaux électriques,
et au-dessus de chaque pixel (2) il y a un filtre couleur, rectangulaire, d'une couleur prédéfinie (R, G, B) et plusieurs pixels (2) directement adjacents formant une cellule de base pixel par pixel avec des filtres (3) de couleurs différentes, et un ensemble de cellules de base forme le capteur d'image, disposé en matrice ou à disposition linéaire,
**caractérisée en ce que**
des zones limites (4) sont prévues entre les filtres couleurs (3) adjacents, dans lesquelles il y a chaque fois un espace libre (7) rempli d'une matière pratiquement opaque.

2. Matrice de filtre couleur selon la revendication 1,
**caractérisée en ce que**
la matière opaque dans l'intervalle (7) est un métal.

3. Matrice de filtre couleur selon les revendications 1 ou 2,
**caractérisée en ce que**
la matière opaque dans l'espace libre (7) est un polymère.

4. Matrice de filtre couleur selon les revendications 1 ou 2,
**caractérisée en ce que**
la matière opaque dans l'espace libre (7) entre les filtres couleurs (3) est réalisé par une gravure faite a posteriori.
